# EUROPEAN PATENT SPECIFICATION

(11) **EP 0 551 488 B1**
(45) Date of publication and mention of the grant of the patent: **23.09.1998**
(21) Application number: 92916864.9
(22) Date of filing: 29.07.1992
(51) Int. Cl.: G01R 33/20, G01R 33/36

(54) **NMR PROBE INCORPORATION RF SHIELDING OF SAMPLE**
Magnetische Kernresonanz-Sonde mit Hochfrequenz-Abschirmung der Sonde.
SONDE DE RESONANCE MAGNETIQUE NUCLEAIRE INCORPORANT UN BLINDAGE HF DE PROTECTION DE L'ECHANTILLON

(30) Priority: 07.08.1991 US 741721
(43) Date of publication of application: 21.07.1993
(60) Divisional application: 98105087.5
(73) Proprietor: VARIAN ASSOCIATES, INC., Palo Alto, California 94304-1030 (US)
(72) Inventor: HILL, Howard, D., W., Cupertino, CA 95014 (US); CUMMINGS, Michael, D., Sunnyvale, CA 94087 (US)
(74) Representative: Cline, Roger Ledlie
(86) International application number: US9206275
(87) International publication number: WO9303390

(56) References cited:
- EP-A- 0 047 065
- EP-A- 0 157 404
- EP-A- 0 303 095
- US-A- 3 783 419
- US-A- 4 879 515
- US-A- 4 910 461
- US-A- 5 017 872
- US-A- 5 038 129
- MAGNETIC RESONANCE IN MEDICINE., vol.2, no.2, 1 April 1985, DULUTH,MN US pages 169 - 175 T.C. NG ET AL. 'SHIELDED SOLENOIDAL PROBE FOR IN VIVO NMR STUDIES OF SOLID TUMORS'
- PATENT ABSTRACTS OF JAPAN vol. 10, no. 316 (P-510) (2372) 28 October 1986 & JP-A-61 126 456 (MITSUBISHI ELECTRIC CORP.) 13 June 1986
- Journal of Magnetic Resonance, 72 (1987), pages 162-167

## Description

### Field of the Invention

The invention is in the field of nuclear magnetic resonance apparatus and particularly relates to improvements in RF probe structure.

### Background of the Invention

In studies of high resolution NMR phenomena one limiting characteristic is the signal-to-noise ratio. The noise has a diverse origin and includes sources other than simple stochastic contributions. It is known that leads of the RF coil may serve as sources of parasitic radiation which may affect a sample under investigation. The present work is predicated upon improvements to RF probe performance incident to incorporating structure having the effect of eliminating, in the sensitive volume of the apparatus, RF signal pickup originating from coil leads and otherwise shielding the sample from discontinuities of the termination of the coil itself (end effects).

The polarizing field of the NMR apparatus is carefully shimmed to provide for the highest achievable uniformity in the central region of the RF coil where the coil design provides for application of the desired irradiation. The sample is ordinarily of extended dimension along one axis to avoid discontinuity in this sensitive volume, but sample regions removed from the center region of the sensitive volume may experience a significantly different polarizing field and therefore resonate at a different frequency. Steps taken to suppress solvent excitation in the center region of the sensitive volume may be ineffective against spurious excitation from coil leads near the ends of the sample. A broad resonance, shifted from the solvent peak can result, masking relatively weak intensity spectral features in this region.

In prior art, an appreciation of the possibility of parasitic excitation arising from radiation from coil leads was discussed in EP-A-0303095. A structure was there described comprising symmetrical excited coil portions with the null point of the coil assembly furnishing a virtual ground for a shield plate disposed between the coil and that portion of the coil leads proximate the coil.

The effect of parasitic RF irradiation from coil leads is especially important in such situations where solvent suppression is required to observe spectral lines close to solvent resonances. With low sample concentration, e.g., 10⁻³ the solvent line(s) are inherently about 10⁶ times as intense as the lines under study. Measures taken for suppression of a solvent resonance assume that such measures (saturation, for example) are ideally achieved. Where the sample has physical extension in regions beyond the sensitive volume and close to coil leads, even very weak radiation of the solvent (in the end portion) of the sensitive volume is sufficient to produce an undesired signal contribution.

The problem is exacerbated in certain composite probe structures. It is not uncommon for two coils to be coaxially disposed with the sample occupying a capillary along the common axis. One example of such structure is the use of quadrature coils. In another common arrangement an inner coil may be provided for ¹³C irradiation and the outer coil provided for proton irradiation. Even in the case where such a probe is in use exclusively for proton resonance measurements and the inner coil is nominally inert, the presence of the inner coil leads, close to a portion of the sample (even though far from the centre of the sensitive volume) provides a means for re-radiating the proton irradiation on the remote sample portion.

EP-A-0303095 discloses an RF coil for applying an RF magnetic field to a sample disposed within said RF coil structure, comprising RF saddle coil means, lead means for connecting said RF saddle coil means for an RF source, shield means disposed between said sample and said RF saddle coil means to shield a portion of said sample proximate said lead means from said lead means, said shield means comprising a hollow cylindrical shell. The shield means is not electrically floating.

US-A-3783419 discloses an RF saddle coil formed by conductors on the outside of an insulating tube, with shield means formed by a continuous ring conductor on the inside of the tube. This ring conductor can be left floating. It does not however have a cap, nor does it extend beyond the RF saddle coil means.

EP-A-0157404 discloses a cylindrical shield in NMR apparatus provided with a cap at one end. The cap is however outside the magnetic field and is not proximate the lead means. The purpose of the shield in the earlier specification is to shield the environment outside the MRI imager bore from RF generated within that bore. Its potential is not floating, because the shield is connected to other shielding outside the coil which is probably connected to ground.

Use of a floating guard ring, coaxially disposed inside of a slotted resonator is described in WO-A-92/17799. This structure was understood to provide capacitive couplings between resonator portions separated by slots, or simply to provide a virtual ground in symmetric geometrical and electrical relationship to an outer ring structure.

The two embodiments of the present invention are disclosed in claims 1 and 3. The invention also relates to the use according to claims 5 and 6.

Examples of the invention will now be described with reference to the accompanying drawings in which:
FIG. 1 illustrates the context of the invention.
FIG. 2(a) shows one embodiment of the invention.
FIG. 2(b) shows one variation for controlled temperature measurements.
FIG. 3a shows an example spectrum obtained without full benefit of the embodiment of FIG. 2.
FIG 3b shows the same example spectrum obtained with the FIG. 2 embodiment.

### Detailed Description of the Present Invention

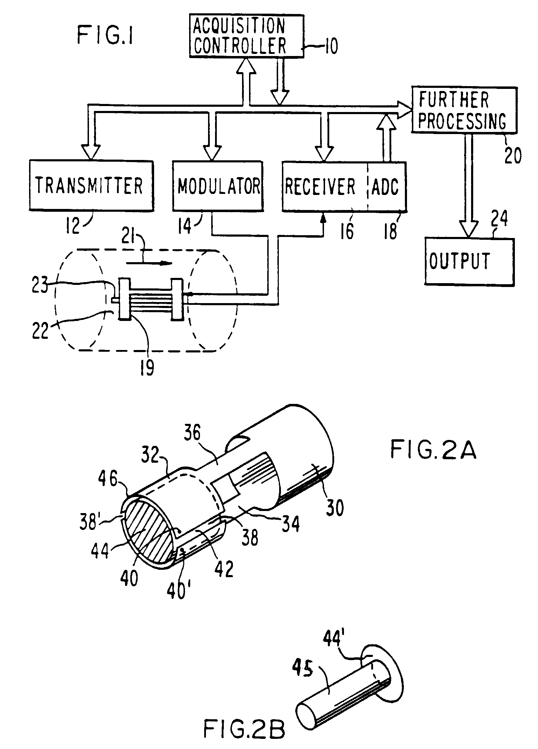

Portions of a typical NMR data acquisition instrument are schematically illustrated in FIG. 1. An acquisition/control processor 10 communicates with an RF transmitter 12, modulator 14 and receiver 16, including analog-to-digital convertor 18 and a further digital processor 20. The modulated RF power irradiates an object 23 in a magnetic field 21 through a probe assembly 22 and response of the object is intercepted by probe 22 communicating with receiver 16. The response typically takes the form of a transient time domain waveform or free induction decay. This transient waveform is sampled at regular intervals and samples are digitized in adc 18. The digitized time domain wave form is then subject to further processing in processor 20. The nature of such processing may include averaging the time domain waveform over a number of similar of such waveforms and transformation of the average time domain wave form to the frequency domain yields a spectral distribution function directed to output device 24. Alternatively this procedure may thus be repeated with variation of some other parameter and the transformation(s) from the data set may take on any of a number of identities for display or further analysis.

The magnetic field 21 which polarizes the sample and defines the Larmor frequency thereof, is established by an appropriate means, not shown. Saddle coil(s) 19 are employed for imposing a desired spacial and time dependence of magnetic field.

Turning now to FIG. 2A, there is shown a single turn saddle coil incorporating the invention. A particular coil structure comprises a ring 30 and ring 32, the latter segmented by gaps 38 and 38'. Rings 30 and 32 are connected by paraxial conductors 34 and 36. Leads 40 and 40' provide the feed from an RF source, e.g. transmitter 12 modulator 14. To this structure there is added a floating inner ring 42, closed off by closure disk 44 proximate to the leads 40 and 40'. A sample tube disposed on the axis of the coil is therefore shielded from parasitic radiation from leads 40 and 40' and from the edge effects of the end 46 of ring 32 of the coil.

Mechanical support (not shown) for the saddle coil of FIG. 2A may be provided by an insulating cylindrical tube or a plurality of small diameter rods as described in U.S. 4,517,516. The floating ring is preferably supported directly from the interior of ring 32, or independently supported.

In a number of measurements, temperature control of the sample is accomplished by flow of a controlled temperature gas stream about the sample. Complete closure of the floating ring 42 with disk 44 would prevent or reduce passage of the gas stream in the portion of the sample adjacent the floating ring 42. Accordingly, the disk 44 may be provided with perforations or the closure may employ a mesh material. At the price of slight degradation of the RF shielding properties of disk 44, the benefit of temperature control of the entire sample is retained. Alternatively, a chimney 45 may be adapted to provide gas flow through closure disk 44' as in FIG. 2(b). The chimney 45 serves to provide the required shielding of the sample from RF leads. In still another alternative, the axial extension of ring 42 may extend beyond the termination of ring 32 by an amount sufficient to assure acceptable shielding.

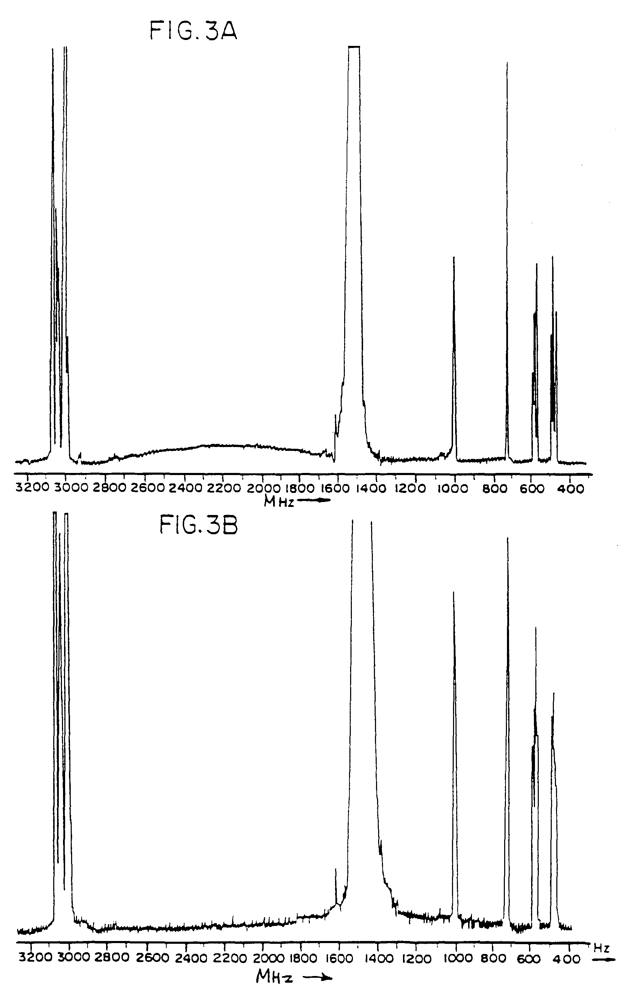

The effect of the closure of the floating ring 42 with disk 44 is illustrated in FIG 3a (without closure disk 44) and FIG. 3b (with closure disk 44) for a sample of phenylalanine in 90% H₂O-10% D₂O. Closure disk 44 contained perforations for temperature control as discussed above. The spectral response of the instrument in the region close to the solvent peak and particularly from 1700 to 2700 MHz is particularly illustrative of the effect of the shielding.

It is to be understood that many changes can be made in the specifically described embodiments without departing from the scope of the invention and that the invention is to be determined from the scope of the following claims without limitation of the specifically described embodiments.

## Claims

1. An RF coil for applying an RF magnetic field to a sample disposed within said RF coil, comprising
(a) RF saddle coil means (19),
(b) lead means (40, 40') for connecting said RF saddle coil means with an RF source, and
(c) electrically floating shield means (42) comprising a hollow cylindrical shell located coaxially inside the coil means and axially overlapping therewith, and characterised in that the shield means additionally comprises a closure disk forming a cap (44) on said shell proximate to said lead means in order to provide RF shielding, and in that the shield means (42) is arranged such that a sample disposed in the coil means (19) is shielded from parasitic radiation from said lead means (40, 40').

2. An RF coil as claimed in claim 1 wherein said closure disk comprises at least one aperture whereby controlled temperature flowing gas contacts a portion of said sample adjacent said closure disk.

3. An RF coil for applying an RF magnetic field to a sample disposed within said RF coil, comprising
(a) RF saddle coil means (19),
(b) lead means (40, 40') for connecting said RF saddle coil means with an RF source, and
(c) electrically floating shield means (42) comprising a hollow cylindrical shell located coaxially inside the coil means and partially axially overlapping therewith, and characterised in that the shield means has an axial length sufficient to extend axially beyond said RF saddle coil means at the end proximate to said lead means, and in that the shield means (42) is arranged such that a sample disposed in the coil means (19) is shielded from parasitic radiation from said lead means (40, 40').

4. An RF coil as claimed in any one of claims 1 to 3 wherein said sample has axial symmetry and said sample, said RF coil means and said floating shield means are disposed coaxially.

5. Use of an electrically floating shield (42), comprising a hollow cylindrical shell, for shielding a sample disposed in an RF saddle coil (19) from parasitic radiation from the lead means (40, 40') connecting the RF saddle coil with an RF source so that no connection of the shield to the null point of the coil is required, the shield additionally comprising a closure disk forming a cap on said shell proximate to said lead means (40,40') in order to provide RF shielding, and being arranged coaxially inside the RF saddle coil in axial overlap therewith.

6. Use of an electrically floating shield (42), comprising a hollow cylindrical shell, for shielding a sample disposed in an RF saddle coil (19) from parasitic radiation from the lead means (40,40') connecting the RF saddle coil with an RF source so that no connection of the shield to the null point of the coil is required, the shield being arranged coaxially inside the RF saddle coil in partial axial overlap therewith and axially extending beyond said RF saddle coil at the end proximate to said lead means.

## Patentansprüche

1. HF-Spule zum Anlegen eines hochfrequenten magnetischen Feldes an eine Probe, die innerhalb der HF-Spule angeordnet ist, mit
(a) HF-Sattelspulenmitteln (19),
(b) Leitungsmitteln (40, 40') zum Verbinden der HF-Sattelspulenmittel mit einer HF-Quelle, und
(c) elektrisch erdfreien Abschirmungsmitteln (42), die ein hohles, zylindrisches Gehäuse aufweisen, welches koaxial innerhalb der Spulenmittel und axial mit diesen überlappend angeordnet ist, und dadurch gekennzeichnet, daß die Abschirmungsmittel zusätzlich eine Abschlußscheibe aufweisen, die einen Deckel (44) auf dem Gehäuse in der Nähe zu den Leitungsmitteln bildet, um HF-Abschirmung zur Verfügung zu stellen, und daß die Abschirmungsmittel (42) derart angeordnet sind, daß eine in den Spulenmitteln (19) angeordnete Probe gegenüber parasitärer Strahlung von den Leitungsmitteln (40, 40') abgeschirmt ist.

2. HF-Spule nach Anspruch 1, wobei die Abschlußscheibe mindestens eine Apertur aufweist, wodurch fließendes, temperaturkontrolliertes Gas einen Abschnitt der Probe benachbart zur der Abschlußscheibe kontaktiert.

3. HF-Spule zum Anlegen eines hochfrequenten magnetischen Feldes an eine innerhalb der HF-Spule angeordnete Probe, mit
(a) HF-Sattelspulenmitteln (19),
(b) Leitungsmitteln (40, 40') zum Verbinden der HF-Sattelspulenmittel mit einer HF-Quelle, und
(c) elektrisch erdfreien Abschirmungsmitteln (42), die ein hohles, zylindrisches Gehäuse aufweisen, welches koaxial innerhalb der Spulenmittel und teilweise mit denselben axial überlappend angeordnet ist, und dadurch gekennzeichnet, daß die Abschirmungsmittel eine axiale Länge aufweisen, die ausreichend ist, sich axial über die HF-Sattelspulenmittel an dem benachbart zu den Leitungsmitteln liegenden Ende zu erstrecken, und daß die Abschirmungsmittel (42) derart angeordnet sind, daß eine in den Spulenmitteln (19) angeordnete Probe gegenüber parasitärer Strahlung der Leitungsmittel (40, 40') abgeschirmt ist.

4. HF-Spule nach einem der Ansprüche 1 bis 3, wobei die Probe axiale Symmetrie aufweist und die Probe, die HF-Spulenmittel und die erdfreien Abschirmungsmittel koaxial angeordnet sind.

5. Verwendung einer elektrisch erdfreien Abschirmung (42), mit einem hohlen, zylindrischen Gehäuse zum Abschirmen einer innerhalb einer HF-Sattelspule (19) angeordneten Probe gegenüber parasitärer Strahlung der Leitungsmittel (40, 40'), welche die HF-Sattelspule mit einer HF-Quelle verbinden, so daß keine Verbindung der Abschirmung mit dem Nullpunkt der Spule benötigt wird, wobei die Abschirmung zusätzlich eine Abschlußscheibe aufweist, welche einen Deckel auf der Abschirmung in der Nähe zu den Leitungsmitteln (40, 40') bildet, um eine HF-Abschirmung zur Verfügung zu stellen, und welches koaxial innerhalb der HF-Sattelspule in axialem Überlapp mit derselben angeordnet ist.

6. Verwendung einer elektrisch erdfreien Abschirmung (42), mit einem hohlen, zylindrischen Gehäuse zum Abschirmen einer innerhalb einer HF-Sattelspule (19) angeordneten Probe gegenüber parasitärer Strahlung der Leitungsmittel (40, 40'), welche die HF-Sattelspule mit einer HF-Quelle verbinden, so daß keine Verbindung der Abschirmung mit dem Nullpunkt der Spule benötigt wird, wobei die Abschirmung koaxial innerhalb der HF-Sattelspule und in teilweisem axialem Überlapp mit derselben und sich axial über die HF-Sattelspule an dem benachbart zu den Leitungsmitteln liegenden Ende hinaus erstreckend angeordnet ist.

## Revendications

1. Bobine HF permettant d'appliquer un champ magnétique HF à un échantillon placé dans ladite bobine HF comprenant :
(a) des moyens de bobine HF en sellette (19),
(b) des moyens de connexion (40, 40') permettant de relier lesdits moyens de bobine HF en sellette à une source HF, et
(c) des moyens de blindage électriquement flottant (42) comprenant une carcasse cylindrique creuse placée coaxialement à l'intérieur des moyens de bobine et se superposant axialement avec ceux-ci,
caractérisée en ce que les moyens de blindage comprennent en plus un disque de fermeture formant un capuchon (44) sur ladite carcasse à proximité desdits moyens de connexion afin de fournir un blindage HF, et en ce que les moyens de blindage (42) sont conçus de telle manière qu'un échantillon disposé dans les moyens de bobine (19) est blindé par rapport aux rayonnements parasites émanant desdits moyens de connexion (40, 40').

2. Bobine HF selon la revendication 1, caractérisée en ce que le disque de fermeture comprend au moins une ouverture par laquelle le gaz de circulation à température contrôlée entre en contact avec une partie dudit échantillon adjacent audit disque de fermeture.

3. Bobine HF permettant d'appliquer un champ magnétique HF à un échantillon placé dans ladite bobine HF, comprenant :
(a) des moyens de bobine HF en sellette (19),
(b) des moyens de connexion (40, 40') permettant de relier lesdits moyens de bobine HF en sellette à une source HF, et
(c) des moyens de blindage électriquement flottant (42) comprenant une carcasse cylindrique creuse placée coaxialement à l'intérieur des moyens de bobine et se superposant partiellement axialement avec ceux-ci,
caractérisée en ce que les moyens de blindage sont dotés d'une longueur axiale suffisante pour dépasser axialement desdits moyens de bobine HF en sellette, à l'extrémité proche desdits moyens de connexion, et en ce que les moyens de blindage (42) sont conçus de telle manière qu'un échantillon disposé dans lesdits moyens de bobine (19) est blindé par rapport aux rayonnements parasites émanant desdits moyens de connexion (40, 40').

4. Bobine HF selon l'une quelconque des revendications 1 à 3, caractérisée en ce que ledit échantillon possède une symétrie axiale et ledit échantillon, lesdits moyens de bobine HF et lesdits moyens de blindage flottant sont coaxiaux.

5. Utilisation d'un blindage électriquement flottant (42), comprenant une carcasse cylindrique creuse, pour blinder un échantillon disposé dans une bobine HF en sellette (19) par rapport aux rayonnements parasites émanant des moyens de connexion (40, 40') reliant la bobine HF en sellette à une source HF de telle manière qu'aucune connexion de blindage au point d'équilibre de la bobine n'est requise, le blindage comprenant en plus un disque de fermeture formant un capuchon sur ledit blindage à proximité desdits moyens de connexion (40, 40'), afin de fournir un blindage HF, et étant disposé coaxialement à l'intérieur de la bobine HF en sellette en se superposant axialement par rapport à celle-ci.

6. Utilisation d'un blindage électriquement flottant (42), comprenant une carcasse cylindrique creuse, pour blinder un échantillon disposé dans une bobine HF en sellette (19) par rapport aux rayonnements parasites émanant des moyens de connexion (40, 40') reliant la bobine HF en sellette à une source HF de telle manière qu'aucune connexion de blindage au point d'équilibre de la bobine n'est requise, le blindage étant disposé coaxialement dans la bobine HF en sellette en se superposant axialement partiellement par rapport à celle-ci et dépassant axialement de ladite bobine HF en sellette à l'extrémité proche desdits moyens de connexion.
